Europäisches Patentamt

European Patent Office

Office européen des brevets

(19)

(11) Publication number: 0 140 975

A1

# (12) EUROPEAN PATENT APPLICATION

published in accordance with Art. 158(3) EPC

(21) Application number: 84901223.2

(22) Date of filing: 19.03.84

Data of the international application taken as a basis:

(86) International application number:
PCT/JP84/00114

(87) International publication number:
WO84/03798 (27.09.84 84/23)

(51) Int. Cl.⁴: H 01 L 21/302

(30) Priority: 18.03.83 JP 46235/83
18.03.83 JP 46236/83

(43) Date of publication of application:
15.05.85 Bulletin 85/20

(84) Designated Contracting States:
DE FR GB

(71) Applicant: Matsushita Electric Industrial Co., Ltd.
1006, Oaza Kadoma
Kadoma-shi Osaka-fu, 571(JP)

(72) Inventor: TOMITA, Kazuyuki
3-14, Hiranohonmachi 1-chome Hirano-ku Osaka-shi
Osaka-fu 547(JP)

(72) Inventor: TANNO, Masuo
4-307, Myokenzaka 5-chome Katano-shi
Osaka-fu 576(JP)

(72) Inventor: YAMADA, Yuichiro
3-14, Shofuryo Miyukihigashimachi Neyagawa-shi
Osaka-fu 572(JP)

(74) Representative: Spencer, Graham Easdale et al,
A.A. Thornton & CO Northumberland House 303-306,
High Holborn
London WC1V 7LE(GB)

(54) REACTIVE ION ETCHING APPARATUS.

(57) The reactive ion etching apparatus is basically similar to a conventional apparatus which subjects an Si material to reactive ion etching. The inner surfaces of a vacuum vessel (1) or a substrate electrode (4) and an opposite electrode (5) are coated with polyethylene tetrafluoride, and a ring (17) of polyethylene tetrafluoride is provided around an object being etched on a substrate electrode, or a porous plate (15) of polyethylene tetrafluoride is provided between the substrate electrode and the opposite electrode. Thus, when discharge starts to take place in a treatment gas of a fluorine compound ($CF_4$, $C_3F_8$, etc.), substances (ions or radicals of fluorine and fluorine compounds) which contribute to the etching are generated from the treatment gas, and substances which contribute to the etching are also generated from the constituent parts coated with the polyethylene tetrafluoride as well as the polyethylene tetrafluoride ring and porous plate. Therefore, unlike in the prior art, it is advantageously possible to increase the etching rate of an Si material without reducing the etching rate ratio selected according to the resist used.

2

SPECIFICATION

TITLE OF THE INVENTION

Reactive Ion Etching Apparatus

TECHNICAL FIELD

This invention relates to a reactive ion etching apparatus in the manufacturing process for electronic parts, such as semiconductors. This invention is directed to provision of a reactive ion etching apparatus for Si series material, which increases an etching rate thereof without increasing the power from a power source.

BACKGROUND ART

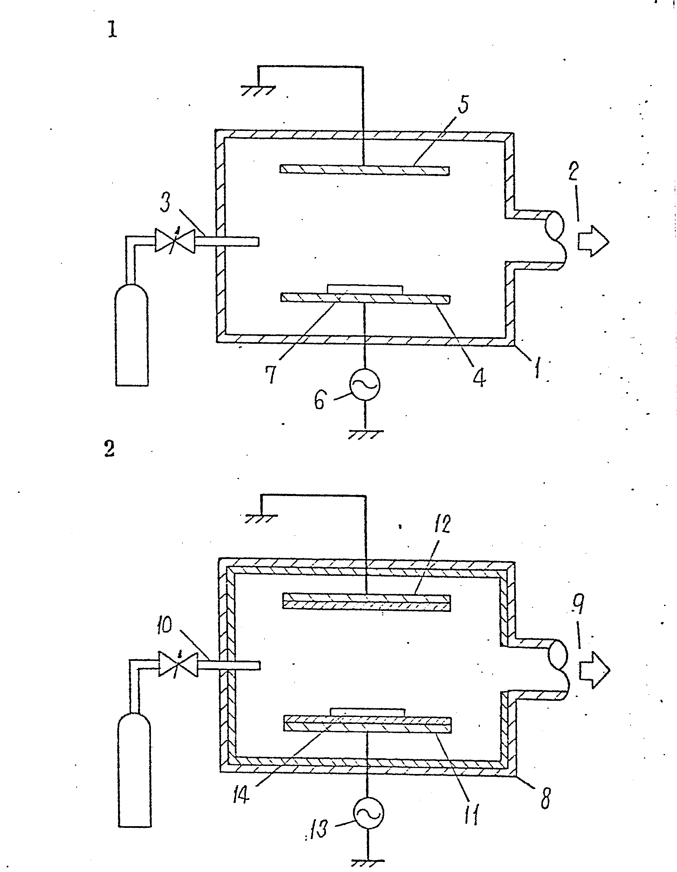

A conventional reactive ion etching apparatus for Si series material, as concretely shown in Fig. 1, has a vacuum container 1 provided with an evacuation end connection 2 connected to an evacuation means (not shown), a working gas supply conduit 3, a substrate electrode 4, and an opposite electrode 5, the substrate electrode 4 connecting to a high frequency power source 6, the working gas having used a fluorine compound ($CF_4$, $C_3F_8$, etc.). Reference numeral 7 designates an object to be etched. Such reactive ion etching apparatus for Si series material, however, should increase the power from a power source in order to increase an etching rate of Si series

- 1 -

material, whereby a selection ratio of etching rate
to a resist material (etching rate of Si series
material/that of resist material) serving as the
master pattern decreases, thereby having been defective in that the reactive ion etching as the master
pattern cannot be carried out.

DISCLOSURE OF THE INVENTION

A reactive ion etching apparatus of the invention is basically the same in construction as the
conventional reactive ion etching apparatus for Si
series material, in which the inner surface of a
vacuum container, a substrate electrode, or an
opposite electrode is coated with polytetrafluoroethylene, a ring made from polytetrafluoroethylene
is provided around the object to be etched on the
substrate electrode, or a perforated plate formed of
polytetrafluoroethylene is interposed between the substrate electrode and the opposite electrode, so that
when electric discharge starts in the working gas of
fluorine compound ($CF_4$, $F_3F_8$, etc.), not only a substance (ion or radical of fluorine and fluorine compound) contributing to etching is produced from the
working gas, but also the substance contributing to
the same is produced from the components: the ring
and perforate plate, coated with polytetrafluoroethylene. Hence, the reactive ion etching apparatus
of the invention has the particular effect such that
the etching rate of Si series material increases
without decreasing the selection ratio of etching
rate with respect to the resist material as the
conventional.

BRIEF DESCRIPTION OF THE DRAWINGS

Fig. 1 is a schematic view of the conventional
reactive ion etching apparatus for Si series material,

Fig. 2 is a schematic view of an embodiment of
a reactive ion etching apparatus for Si series
material of the invention, and

Fig. 3 is a graph showing the result in comparison of a relation between the high frequency power
and a $SiO_2$ film in this embodiment and conventional
example with that of selection ratio between the high
frequency power and the etching rate.

BEST MODE FOR CARRYING OUT THE INVENTION

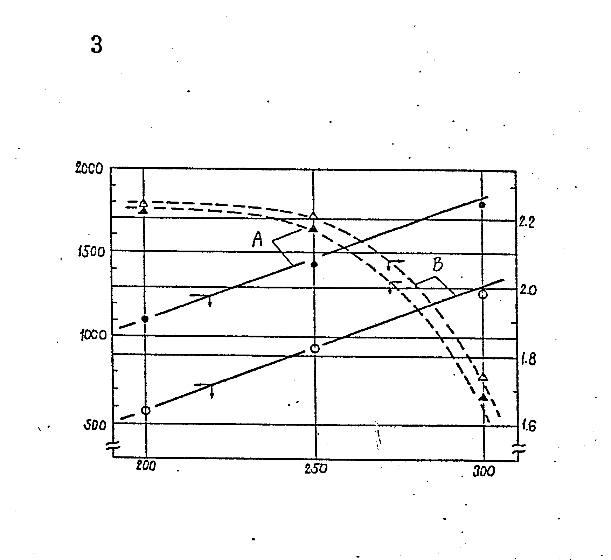

Next, an embodiment of the invention will be
described in accordance with Figs. 2 and 3. Fig. 2
is a schematic view of the embodiment of a reactive
ion etching apparatus for Si series material of the
invention, in which reference numeral 8 designates
a vacuum container, 9 designates an evacuation outlet, 10 designates a working gas supply inlet, 11 designates a substrate electrode, 12 designates an opposite electrode, 13 designates a high frequency power source, and 14 designates an object to be etched, 15 designates a perforated plate formed of polytetrafluoroethylene, the perforated plate 15 used in this embodiment having bores each of 8 mm in diameter, 10 mm in bore pitch, and 3 mm in thickness, 16 designates stays for supporting the perforated plate and formed of an alumina insulator, the stays 16 in this embodiment having been designed to keep an interval of 10 mm between the perforated bore plate and the object to be etched (the upper surface of wafer), and 17 designates a ring of polytetrafluoroethylene. The ring 17 used in this embodiment is 101 mm in an inner diameter, 152 mm in an outer diameter, and 3 mm in thickness. The apparatus constructed as foregoing is used to carry out the reactive ion etching for Si series material of the invention under the following etching conditions:

| | |
|---|---|
| Working gas: | $C_3F_8$ (Perfluoropropane) |
| Gas flow rate: | 50 SCCM |
| Degree of vacuum: | 0.08 Torr |
| Power supplied: | 200 to 300 W |
| Object to be etched: | $SiO_2$ film on a Si wafer of 100 m$\phi$ in an outer diameter (6000 Å) |

Fig. 3 is a graph showing the result in comparison of the selection ratio of the etching rate of $SiO_2$ film to that of the resist material in this embodiment with the reactive ion etching carried out by use of the conventional apparatus in Fig. 1 under the same condition as this embodiment, in which the line A shows the result in this embodiment and B the conventional example. As seen from Fig. 3, in this embodiment, the ring of polytetrafluoroethylene is provided around the object to be etched and the perforated plate of polytetrafluoroethylene is provided between the opposite electrode and the substrate electrode, thereby enabling the etching rate of $SiO_2$ film to increase without reducing the selection ratio of etching rate to the resist material. The reason for this is that the provision of the ring and perforated plate formed of polytetrafluoroethylene, when electric discharge starts in the working gas of fluorine compound $(C_3F_8)$, produces also from polytetrafluoroethylene substances contributing to etching other than those of ion or radical of fluorine and fluorine compound produced from the working gas and contributing to etching.

Alternatively, the perforated plate 15 and ring 17 of polytetrafluoroethylene in this embodiment may be either one only. Also, when at least one of the inner surface of vacuum container 8, substrate electrode 11 and opposite electrode 12, is coated with polytetrafluoroethylene, the ion etching apparatus of the invention of course has the effect as abovementioned. Furthermore, the object to be etched may alternatively be any one of single crystal, polycrystalline Si film and silicon nitride film.

INDUSTRIAL APPLICABILITY

As seen from the above, the Si series material reactive ion etching apparatus of the invention is so constructed that one, two or the whole of the inner surface of vacuum container, opposite electrode and substrate electrode, is coated with polytetrafluoroethylene, the ring formed thereof is provided around the object to be etched, or the perforated plate is interposed between the opposite electrode and the substrate electrode, thereby enabling the etching rate of Si series material to increase without reducing the selection ratio of etching rate to the resist, thereby having a higher etching effect.

What is claimed is:

1. A reactive ion etching apparatus comprising a vacuum container, an evacuation means provided in continuation of said vacuum container, a working gas supply means provided in continuation of said vacuum container, a substrate electrode provided in said vacuum container and for carrying an object to be etched, an opposite electrode provided opposite to said substrate electrode, and a high-frequency power source connected electrically to one of said electrodes in said vacuum container, said vacuum container or said members therein being applied with coating of polytetrafluoroethylene, or members formed of polytetrafluoroethylene are provided in the region of generating plasma within said vacuum container.

2. A reactive ion etching apparatus as set forth in Claim 1, wherein at least one of the inner surface of said vacuum container, substrate electrode, and opposite electrode, is coated overall or in part the surface with polytetrafluoroethylene.

3. A reactive ion etching apparatus as set forth in Claim 1, wherein a ring, as the member formed of polytetrafluoroethylene, is provided around said object to be etched on said substrate electrode.

- 8 -

4. A reactive ion etching apparatus as set forth in Claim 1, wherein a perforated plate, as the member formed of polytetrafluoroethylene, is provided between said substrate electrode and said opposite electrode.

1

2

17·12·84

0140975

3

# INTERNATIONAL SEARCH REPORT

International Application No PCT/JPS4/00114 **0140975**

| I. CLASSIFICATION OF SUBJECT MATTER (if several classification symbols apply, indicate all) |
|---|
| According to International Patent Classification (IPC) or to both National Classification and IPC |
| Int. Cl$^3$  H01L21/302 |

## II. FIELDS SEARCHED

| Minimum Documentation Searched | |
|---|---|
| Classification System | Classification Symbols |
| IPC | H01L21/302 |

| Documentation Searched other than Minimum Documentation to the Extent that such Documents are Included in the Fields Searched | |
|---|---|
| Jitsuyo Shinan Koho | 1926 – 1983 |
| Kokai Jitsuyo Shinan Koho | 1971 – 1983 |

## III. DOCUMENTS CONSIDERED TO BE RELEVANT

| Category* | Citation of Document, with indication, where appropriate, of the relevant passages | Relevant to Claim No |
|---|---|---|
| X | JP, A, 58-43522 (Western Electric Co., Inc.), 14 March 1983 (14. 03. '83), Page 5, lower left column, lines 7 to 16  & US.A.4397724 | 1 – 4 |
| T | JP, A, 58-170018 (Fujitsu Ltd.), 6 October 1983 (06. 10. 83) | 1 – 4 |

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance, the claimed invention cannot be considered novel or cannot be considered to involve an inventive step
"Y" document of particular relevance, the claimed invention cannot be considered to involve an inventive step when the document is combined with one or more other such documents, such combination being obvious to a person skilled in the art
"&" document member of the same patent family

## IV. CERTIFICATION

| Date of the Actual Completion of the International Search | Date of Mailing of this International Search Report |
|---|---|
| June 8, 1984   (08. 06. 84) | June 18, 1984   (18. 06. 84) |

| International Searching Authority | Signature of Authorized Officer |
|---|---|
| Japanese Patent Office | |

Form PCT/ISA/210 (second sheet) (October 1981)